# EUROPEAN PATENT APPLICATION

(11) **EP 4 730 941 A1**
(43) Date of publication of application: **22.04.2026**
(21) Application number: 25209584.9
(22) Date of filing: 17.10.2025
(51) Int. Cl.: H05K 7/20

(54) **AIR AND LIQUID COOLING DISTRIBUTION UNIT**

(30) Priority: 17.10.2024 US 202463708650 P; 15.10.2025 US 202519359196
(71) Applicant: Vertiv International GmbH, 8212 Neuhausen am Rheinfall (CH)
(72) Inventor: MASETTO, FILIPPO, 8212 Neuhausen am Rheinfall (CH); MICONI, ENRICO, 8212 Neuhausen am Rheinfall (CH)
(74) Representative: Cousens, Nico

(57) **Abstract**

A cooling system can include a cooling fluid supply line for receiving cooling fluid at a first temperature from a cooling fluid chiller system, a fluid-to-air heat exchanger fluidically coupled to the cooling fluid supply line for selectively transferring heat from air to the cooling fluid and heating the cooling fluid to a second temperature, a fluid-to-fluid heat exchanger fluidically coupled to the fluid-to-air heat exchanger for selectively transferring heat from one or more cold plates to the cooling fluid and heating the cooling fluid to a third temperature, and a cooling fluid return line fluidically coupled to the fluid-to-fluid heat exchanger and configured to return the cooling fluid at the third temperature to the cooling fluid chiller system. The fluid-to-air heat exchanger and the fluid-to-fluid heat exchanger can be fluidically coupled in series between the cooling fluid supply line and the cooling fluid return line.

## Description

### CROSS-REFERENCE TO RELATED APPLICATION(S)

Thia application claims the benefit of U.S. Provisional Patent Application No. 63/708,650 filed October 17, 2024.

### TECHNICAL FIELD

The present disclosure relates generally to cooling systems for data centers, and more specifically relates to cooling systems utilizing both liquid cooling and air cooling.

### BACKGROUND

Increased computing demands are leading to numerous challenges for data center operators in managing cooling, and in particular in optimizing space and the operation of hybrid air and liquid cooling systems. Conventional approaches involve installing dedicated and separate solutions for air cooling and liquid cooling, which often require different supply temperatures, leading to complex and very often non-optimized systems.

### SUMMARY

Applicant has created new and useful devices, systems and methods for cooling systems utilizing both liquid cooling and air cooling. A cooling system according to the disclosure can provide significant efficiencies and flexibilities as either a newly installed system or in retrofitting existing equipment, simplify plumbing and electrical connections to and between air cooling components and liquid cooling components, and efficiently accommodate different supply temperatures of the air cooling components and the liquid cooling components. A cooling system according to the disclosure can selectively operate the air cooling and the liquid cooling components in series or parallel and/or bypass either.

In at least one embodiment, a cooling system according to the disclosure can include a cooling fluid supply line for receiving cooling fluid at a first temperature from a cooling fluid chiller system, a fluid-to-air heat exchanger fluidically coupled to the cooling fluid supply line for selectively transferring heat from air to the cooling fluid and heating the cooling fluid to a second temperature, a fluid-to-fluid heat exchanger fluidically coupled to the fluid-to-air heat exchanger for selectively transferring heat from one or more cold plates to the cooling fluid and heating the cooling fluid to a third temperature, a cooling fluid return line fluidically coupled to the fluid-to-fluid heat exchanger and configured to return the cooling fluid at the third temperature to the cooling fluid chiller system, or any combination thereof. In at least one embodiment, the second temperature can be higher than the first temperature. In at least one embodiment, the third temperature can be higher than the first temperature and/or the second temperature. In at least one embodiment, the fluid-to-air heat exchanger and the fluid-to-fluid heat exchanger can be fluidically coupled in series between the cooling fluid supply line and the cooling fluid return line.

In at least one embodiment, any or all of the cooling fluid that flows through the fluid-to-air heat exchanger can flow or be routed through the fluid-to-fluid heat exchanger before entering the cooling fluid return line. In at least one embodiment, any or all of the cooling fluid entering the fluid-to-fluid heat exchanger can first flow through the fluid-to-air heat exchanger before entering the fluid-to-fluid heat exchanger. In at least one embodiment, the cooling fluid can enter the fluid-to-fluid heat exchanger at the second temperature or between the first temperature and the second temperature and/or exit the fluid-to-fluid heat exchanger at the third temperature.

In at least one embodiment, the fluid-to-air heat exchanger and the fluid-to-fluid heat exchanger can be combined into one unit and/or disposed within a single enclosure. In at least one embodiment, the enclosure can be disposed in one room of a building and the cold plates can be disposed within the same or another room of the building. In at least one embodiment, at least a portion of the cooling fluid chiller system can be disposed outside the building. In at least one embodiment, the system can include one cooling fluid supply coupler coupled to the enclosure and that fluidically couples the cooling fluid supply line to the fluid-to-air heat exchanger and/or one cooling fluid return coupler coupled to the enclosure and that fluidically couples the cooling fluid return line to the fluid-to-fluid heat exchanger, which can simplify installation of the system.

In at least one embodiment, the system can include a first three-way valve fluidically coupled to the cooling fluid supply coupler and/or the cooling fluid supply line. In at least one embodiment, the first three-way valve can be fluidically coupled between the cooling fluid supply coupler and the fluid-to-air heat exchanger, between the cooling fluid supply line and the fluid-to-air heat exchanger, between the fluid-to-air heat exchanger and the fluid-to-fluid heat exchanger, between the cooling fluid supply coupler and the fluid-to-fluid heat exchanger, between the cooling fluid supply line and the fluid-to-fluid heat exchanger, or any combination thereof.

In at least one embodiment, the first three-way valve can select between the cooling fluid at the first temperature from the cooling fluid supply coupler (or the cooling fluid supply line) and the cooling fluid at the second temperature from the fluid-to-air heat exchanger and supply the selected cooling fluid to the fluid-to-fluid heat exchanger, selectively mix the cooling fluid at the first temperature from the cooling fluid supply coupler (or the cooling fluid supply line) with the cooling fluid at the second temperature from the fluid-to-air heat exchanger and supply the mixed cooling fluid to the fluid-to-fluid heat exchanger, direct the cooling fluid at the first temperature from the cooling fluid supply coupler (or the cooling fluid supply line) to the fluid-to-air heat exchanger and/or the fluid-to-fluid heat exchanger, or any combination thereof.

In at least one embodiment, the system can include a second three-way valve fluidically coupled to the fluidically coupled to cooling fluid return coupler and/or the cooling fluid return line. In at least one embodiment, the three-way valve can be fluidically coupled between the cooling fluid return coupler and the fluid-to-air heat exchanger, between the cooling fluid return line and the fluid-to-air heat exchanger, between the fluid-to-air heat exchanger and the fluid-to-fluid heat exchanger, between the cooling fluid return coupler and the fluid-to-fluid heat exchanger, between the cooling fluid return line and the fluid-to-fluid heat exchanger, or any combination thereof. In at least one embodiment, the second three-way valve can direct the cooling fluid at the second temperature from the fluid-to-air heat exchanger to the cooling fluid return coupler, the cooling fluid return line, the fluid-to-fluid heat exchanger, or any combination thereof.

In at least one embodiment, a method according to the disclosure can be used to more efficiently configure a cooling system, such as an existing cooling system having a cooling fluid supply line, a fluid-to-air heat exchanger, a fluid-to-fluid heat exchanger, a cooling fluid return line, or any combination thereof. In at least one embodiment, the method can include disconnecting an outlet of the fluid-to-air heat exchanger from the cooling fluid return line, disconnecting an inlet of the fluid-to-fluid heat exchanger from the cooling fluid supply line, fluidically coupling the outlet of the fluid-to-air heat exchanger to the inlet of the fluid-to-fluid heat exchanger. In at least one embodiment, the method can direct cooling fluid to flow from the cooling fluid supply line, through the fluid-to-air heat exchanger, through the fluid-to-fluid heat exchanger, and then to the cooling fluid return line.

### BRIEF DESCRIPTION OF THE DRAWINGS

FIG. 1 is a simplified schematic view of a prior art cooling system.
FIG. 2 is a simplified schematic view of one of many embodiments of a cooling system according to the disclosure.
FIG. 3 is a simplified schematic view of another one of many embodiments of a cooling system according to the disclosure.
FIG. 4 is a simplified schematic view of yet another one of many embodiments of a cooling system according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various embodiments of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of flowchart illustration can be implemented by special purpose hardware-based systems that perform the specified functions or acts, or combinations of special purpose hardware and computer instructions.

Applicant has created new and useful devices, systems and methods for cooling systems utilizing both liquid cooling and air cooling. A cooling system according to the disclosure can provide significant efficiencies and flexibilities as either a newly installed system or in retrofitting existing equipment, simplify plumbing and electrical connections to and between air cooling components and liquid cooling components, and efficiently accommodate different supply temperatures of the air cooling components and the liquid cooling components. A cooling system according to the disclosure can selectively operate the air cooling and the liquid cooling components in series or parallel and/or bypass either.

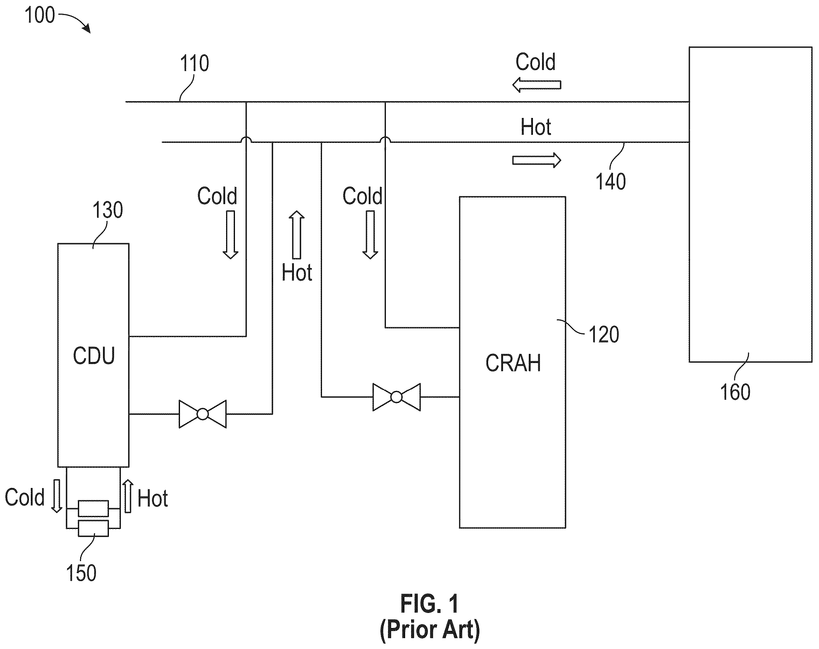

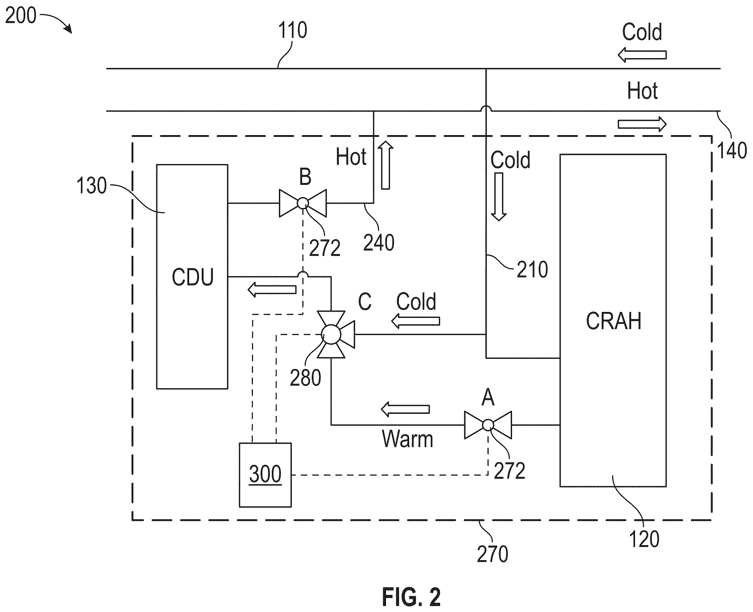

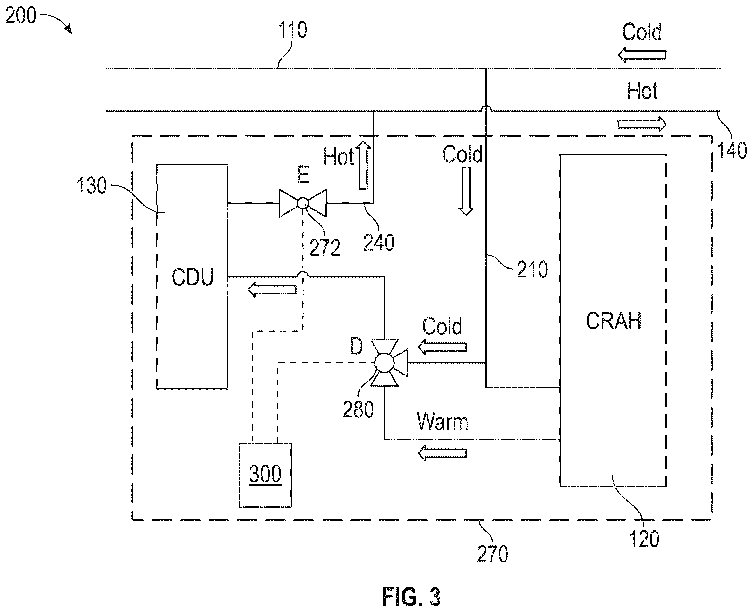

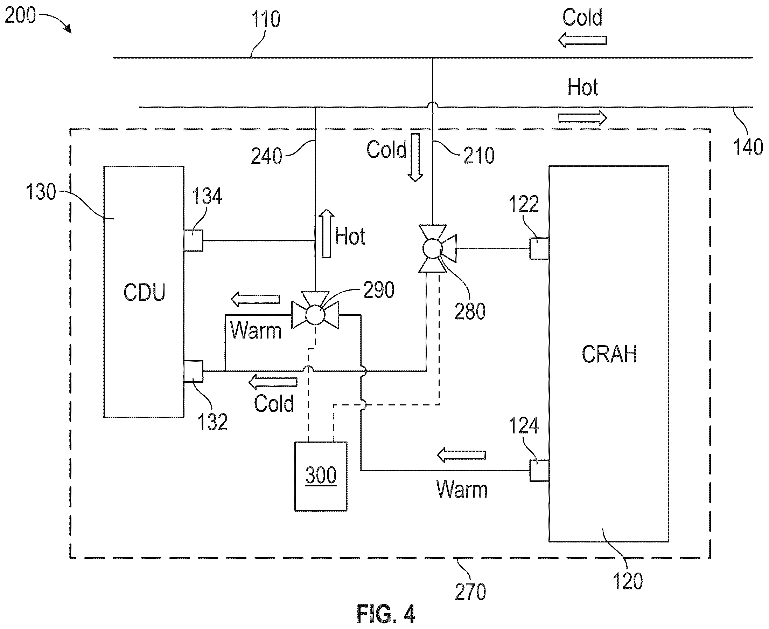

FIG. 1 is a simplified schematic view of a prior art cooling system. FIG. 2 is a simplified schematic view of one of many embodiments of a cooling system according to the disclosure. FIG. 3 is a simplified schematic view of another one of many embodiments of a cooling system according to the disclosure. FIG. 4 is a simplified schematic view of yet another one of many embodiments of a cooling system according to the disclosure. FIGS. 1-4 are described in conjunction with one another.

As shown in FIG. 1, for example, a prior art cooling system 100 can have a cooling fluid supply line 110, a fluid-to-air heat exchanger 120 (such as a computer room air handler (CRAH)), a fluid-to-fluid heat exchanger 130 (such as a coolant distribution unit (CDU)), a cooling fluid return line 140, or some combination thereof. The fluid-to-fluid heat exchanger 130 might be used to cool one or more cold plates 150. Cooling fluid, circulating through such a system 100, can be cooled by a chiller system 160. Such a prior art cooling system 100, as shown, can have the fluid-to-air heat exchanger 120 and the fluid-to-fluid heat exchanger 130 plumbed in parallel, between the cooling fluid supply line 110 and the cooling fluid return line 140. This can result in both the fluid-to-air heat exchanger 120 and the fluid-to-fluid heat exchanger 130 receiving the cooling fluid at the same supply temperature and the cooling fluid they heat being mixed, such that the return temperature, returned to the chiller system 160, is somewhere between the two.

This can result in several inefficiencies. For example, the fluid-to-air heat exchanger 120 can be efficiently operated with a supply temperature around 20 degrees to provide an output temperature of around 30 degrees (unless otherwise indicated, all temperatures discussed herein are expressed in degrees Celsius). At the same time, the fluid-to-fluid heat exchanger 130 can be efficiently operated with a supply temperature around 30 degrees to provide an output temperature of around 40 degrees. Thus, where the fluid-to-air heat exchanger 120 and the fluid-to-fluid heat exchanger 130 share the same supply temperature, one or both may not be operating as efficiently as possible. As another example, assuming the above-mentioned output temperatures, the cooling fluid can be returned to the chiller system 160 at some temperature between the two, or around 35 degrees. Thus, the chiller system 160 can operate with a limited temperature difference of around 15 degrees.

Embodiments of the present disclosure can address the shortcomings described above and can advantageously provide for more efficient cooling operations. In at least one embodiment, a cooling system 200 according to the disclosure can include one or more cooling fluid supply lines 110 for receiving cooling fluid at a first temperature from one or more cooling fluid chiller systems 160, one or more fluid-to-air heat exchangers 120 fluidically coupled to the cooling fluid supply line 110 for selectively transferring heat from air to the cooling fluid to heat the cooling fluid to a second temperature, one or more fluid-to-fluid heat exchangers 130 fluidically coupled to the fluid-to-air heat exchanger 120 for selectively transferring heat from one or more cold plates 150 to the cooling fluid to heat the cooling fluid to a third temperature, one or more cooling fluid return lines 140 fluidically coupled to the fluid-to-fluid heat exchanger 130 and configured to return the cooling fluid at the third temperature to the cooling fluid chiller system 160, or any combination thereof.

In at least one embodiment, the cold plates 150 can be located within the same room as the fluid-to-fluid heat exchanger 130 and/or the fluid-to-air heat exchanger 120. In at least one embodiment, the cold plates 150 can be located within the separate room as the fluid-to-fluid heat exchanger 130 and/or the fluid-to-air heat exchanger 120. In at least one embodiment, the cold plates 150 can be located within the same room as the fluid-to-fluid heat exchanger 130 and a separate room as the fluid-to-air heat exchanger 120. In at least one embodiment, the cooling fluid, or another cooling fluid, can be circulated through the fluid-to-fluid heat exchanger 130 and/or the cold plates 150 using one or more pumps and/or valves. In at least one embodiment, the chiller system 160, can be located outside a building housing the system 200 and/or can include one or more pumps and/or valves to control the circulation of the cooling fluid.

In at least one embodiment, the first (cold) temperature can be between 15 and 25 degrees, such as about 20 degrees, for example. In at least one embodiment, the second (warm) temperature can be higher than the first temperature. In at least one embodiment, the second temperature can be between 25 and 35 degrees, such as about 28 or 30 degrees, for example. In at least one embodiment, the third (hot) temperature can be higher than the first temperature and/or the second temperature. In at least one embodiment, the third temperature can be between 35 and 45 degrees, such as about 40 degrees, for example. In at least one embodiment, the fluid-to-air heat exchanger 120 and the fluid-to-fluid heat exchanger 130 can be fluidically coupled in series between the cooling fluid supply line 110 and the cooling fluid return line 140. In at least one embodiment, the fluid-to-air heat exchanger 120 can receive the cooling fluid from the chiller 160 at the first (cold) temperature and output the cooling fluid at the second (warm) temperature. In at least one embodiment, the fluid-to-fluid heat exchanger 130 can receive the cooling fluid at the second temperature from the fluid-to-air heat exchanger 120 and output the cooling fluid at the third (hot) temperature for return to the chiller system 160. Thus, in at least one embodiment, both the fluid-to-air heat exchanger 120 and the fluid-to-fluid heat exchanger 130 can receive more efficient supply temperatures and the chiller system 160 can operate with a larger temperature differential, which can permit the chiller system 160 to be more efficient. In at least one embodiment, the fluid-to-air heat exchanger 120 can operate at a lower supply temperature than the fluid-to-fluid heat exchanger 130, the fluid-to-fluid heat exchanger 130 can operate at a higher temperature than the fluid-to-air heat exchanger 120, and the chiller system 160 can operate at an increased temperature differential, increasing free-cooling and reducing pump power consumption. In at least one embodiment, the fluid-to-air heat exchanger 120 can operate at a lower flow rate than the fluid-to-fluid heat exchanger 130, and the fluid-to-fluid heat exchanger 130 can operate at a higher flow rate than the fluid-to-air heat exchanger 120, which can provide proper circuit balancing, reduce overall flow rate, and reduce pump power consumption.

In at least one embodiment, any or all of the cooling fluid that flows through the fluid-to-air heat exchanger 120 can flow or be routed through the fluid-to-fluid heat exchanger 130 before entering the cooling fluid return line 140. In at least one embodiment, any or all of the cooling fluid entering the fluid-to-fluid heat exchanger 130 can first flow through the fluid-to-air heat exchanger 120 before entering the fluid-to-fluid heat exchanger 130. In at least one embodiment, the cooling fluid can enter the fluid-to-fluid heat exchanger 130 at the second temperature or between the first temperature and the second temperature and/or exit the fluid-to-fluid heat exchanger 130 at the third temperature.

In at least one embodiment, the fluid-to-air heat exchanger 120 and the fluid-to-fluid heat exchanger 130 can be combined into one unit and/or disposed within a single enclosure 270. In at least one embodiment, the enclosure can be disposed in one room of a building and the cold plates 150 can be disposed within the same or another room of the building. In at least one embodiment, at least a portion of the cooling fluid chiller system 160 can be disposed outside the building, such as for rejecting heat outside of the building. In at least one embodiment, the system 200 can include a cooling fluid supply coupler 210 coupled to the enclosure 270, such as by way of being disposed at least partially through a wall or other portion thereof, and that fluidically couples the cooling fluid supply line 110 to the fluid-to-air heat exchanger 120 and/or a cooling fluid return coupler 240 coupled to the enclosure 270 and that fluidically couples the cooling fluid return line 140 to the fluid-to-fluid heat exchanger 130. In at least one embodiment, the system 200 can have only a single cooling fluid supply coupler 210 and only a single cooling fluid return coupler 240, which can, e.g., reduce costs and complexity, and simplify installation of the system 200. For example, rather than coupling the fluid-to-air heat exchanger 120 and the fluid-to-fluid heat exchanger 130 to both the cooling fluid supply line 110 and the cooling fluid return line 140 separately, or independently, the system 200 can be arranged with only one connection to the cooling fluid supply line 110 and only one connection to the cooling fluid return line 140. In at least one embodiment, one or more electrical connections or wiring arrangements can be similarly simplified.

In at least one embodiment, the system 200 can provide both air and liquid cooling in a single unit, and/or a single one enclosure 270, significantly reducing installation times and/or costs and allowing a data center operator to be extremely flexible in the types of servers to be initially and/or later installed. In at least one embodiment, the system 200 and/or the enclosure 270 can be installed in a data center, either in the same room as the servers or in a different room, which can allow maintenance on the system 200 to be performed from a service corridor without compromising security within the server room.

In at least one embodiment, the system 200 can include one or more inlet valves, such as a three-way inlet valve 280, fluidically coupled to the cooling fluid supply coupler 210 and/or the cooling fluid supply line 110. In at least one embodiment, the three-way inlet valve 280 can be fluidically coupled between the cooling fluid supply coupler 210 and the fluid-to-air heat exchanger 120, between the cooling fluid supply line 110 and the fluid-to-air heat exchanger 120, between the fluid-to-air heat exchanger 120 and the fluid-to-fluid heat exchanger 130, between the cooling fluid supply coupler 210 and the fluid-to-fluid heat exchanger 130, between the cooling fluid supply line 110 and the fluid-to-fluid heat exchanger 130, or any combination thereof.

In at least one embodiment, the three-way inlet valve 280 can be fluidically coupled between an outlet 124 of the fluid-to-air heat exchanger 120 and any or all of the cooling fluid supply coupler 210, the cooling fluid supply line 110, an inlet 122 of the fluid-to-air heat exchanger 120. In at least one embodiment, the three-way inlet valve 280 can be fluidically coupled between the outlet 124 of the fluid-to-air heat exchanger 120 and an inlet 132 of the fluid-to-fluid heat exchanger 130. In at least one embodiment, the three-way inlet valve 280 can be fluidically coupled the inlet 132 of the fluid-to-fluid heat exchanger 130 and any or all of the cooling fluid supply coupler 210, the cooling fluid supply line 110, the inlet 122 of the fluid-to-air heat exchanger 120. In at least one embodiment, the three-way inlet valve 280 can be fluidically coupled between the cooling fluid supply coupler 210 (or the cooling fluid supply line 110) and the inlet 122 of the fluid-to-air heat exchanger 120, between the inlet 122 of the fluid-to-air heat exchanger 120 and the inlet 132 of the fluid-to-fluid heat exchanger 130, between the cooling fluid supply coupler 210 (or the cooling fluid supply line 110) and the inlet 132 of the fluid-to-fluid heat exchanger 130, or any combination thereof.

In at least one embodiment, the three-way inlet valve 280 can select between the cooling fluid at the first temperature from the cooling fluid supply coupler 210 (or the cooling fluid supply line 110) and the cooling fluid at the second temperature from the fluid-to-air heat exchanger 120 and supply the selected cooling fluid to the fluid-to-fluid heat exchanger 130. In at least one embodiment, the three-way inlet valve 280 can supply the cooling fluid to the fluid-to-fluid heat exchanger 130 at either the first temperature or the second temperature. In at least one embodiment, the three-way inlet valve 280 can supply the cooling fluid to the fluid-to-fluid heat exchanger 130 bypassing the fluid-to-air heat exchanger 120, such as for maintenance, replacement, repair, or another operating issue.

In at least one embodiment, the three-way inlet valve 280 can selectively mix the cooling fluid at the first temperature from the cooling fluid supply coupler 210 (or the cooling fluid supply line 110) with the cooling fluid at the second temperature from the fluid-to-air heat exchanger 120 and supply the mixed cooling fluid to the fluid-to-fluid heat exchanger 130. In at least one embodiment, the three-way inlet valve 280 can supply the mixed cooling fluid to the fluid-to-fluid heat exchanger 130 at a temperature between the first temperature and the second temperature. In at least one embodiment, the three-way inlet valve 280 can supply adequate cooling fluid to the fluid-to-fluid heat exchanger 130, such as when the fluid-to-air heat exchanger 120 is operated at a lower cooling fluid flow than desired for the fluid-to-fluid heat exchanger 130. In at least one embodiment, the three-way inlet valve 280 can make-up sufficient cooling fluid flow to the fluid-to-fluid heat exchanger 130, such as when flow through the fluid-to-air heat exchanger 120 is inadequate for the fluid-to-fluid heat exchanger 130.

In at least one embodiment, the three-way inlet valve 280 can direct the cooling fluid at the first temperature from the cooling fluid supply coupler 210 (or the cooling fluid supply line 110) to the fluid-to-air heat exchanger 120 and/or the fluid-to-fluid heat exchanger 130, or any combination thereof. In at least one embodiment, the three-way inlet valve 280 can direct the cooling fluid to the fluid-to-air heat exchanger 120 and/or the fluid-to-fluid heat exchanger 130, bypassing either, such as when to the fluid-to-air heat exchanger 120 and/or the fluid-to-fluid heat exchanger 130 is taken out of service for maintenance, replacement, repair, or another operating issue.

In at least one embodiment, the three-way inlet valve 280 can direct the cooling fluid flowing through the fluid-to-air heat exchanger 120 to the fluid-to-fluid heat exchanger 130. In at least one embodiment, the three-way inlet valve 280 can limit the cooling fluid flowing through the fluid-to-fluid heat exchanger 130 to that which first flows through the fluid-to-air heat exchanger 120. In at least one embodiment, the three-way inlet valve 280 can mix the cooling fluid flowing through the fluid-to-air heat exchanger 120 with cooling fluid from the cooling fluid supply line 110 and/or the cooling fluid supply coupler 210 (without flowing through the fluid-to-air heat exchanger 120) and direct the mixture to the fluid-to-fluid heat exchanger 130. In at least one embodiment, the three-way inlet valve 280 can mix warm cooling fluid from the fluid-to-air heat exchanger 120 with cold cooling fluid from the cooling fluid supply line 110 and/or the cooling fluid supply coupler 210 and direct the mixture to the fluid-to-fluid heat exchanger 130. In at least one embodiment, such as when the inlet valve 280 is completely opened for the fluid-to-air heat exchanger 120, all of the flow can be in series, i.e., through the fluid-to-air heat exchanger 120 and then through the fluid-to-fluid heat exchanger 130. In at least one embodiment, such as when the inlet valve 280 is modulating (or modulated, e.g., by controller 300 further described below), there can be a mixture of flow from the fluid-to-air heat exchanger 120 and the cooling fluid supply line 110 and/or the cooling fluid supply coupler 210.

In at least one embodiment, the system 200 can include one or more three-way outlet valves 290 fluidically coupled to the fluidically coupled to cooling fluid return coupler 240 and/or the cooling fluid return line 140. In at least one embodiment, the three-way outlet valve 290 can be fluidically coupled between the cooling fluid return coupler 240 and the fluid-to-air heat exchanger 120, between the cooling fluid return line 140 and the fluid-to-air heat exchanger 120, between the fluid-to-air heat exchanger 120 and the fluid-to-fluid heat exchanger 130, between the cooling fluid return coupler 240 and the fluid-to-fluid heat exchanger 130, between the cooling fluid return line 140 and the fluid-to-fluid heat exchanger 130, or any combination thereof.

In at least one embodiment, the three-way outlet valve 290 can be fluidically coupled between an outlet 124 of the fluid-to-air heat exchanger 120 and any or all of the outlet 134 of the fluid-to-fluid heat exchanger 130, the cooling fluid return coupler 240, and the cooling fluid return line 140. In at least one embodiment, the three-way outlet valve 290 can be fluidically coupled between the outlet 124 of the fluid-to-air heat exchanger 120 and the inlet 132 of the fluid-to-fluid heat exchanger 130. In at least one embodiment, the three-way outlet valve 290 can be fluidically coupled between the inlet 132 of the fluid-to-fluid heat exchanger 130 and any or all of the outlet 134 of the fluid-to-fluid heat exchanger 130, the cooling fluid return coupler 240, and the cooling fluid return line 140.

In at least one embodiment, the three-way outlet valve 290 can direct the cooling fluid at the second temperature from the fluid-to-air heat exchanger 120 to the cooling fluid return coupler 240, the cooling fluid return line 140, the fluid-to-fluid heat exchanger 130, or any combination thereof. In at least one embodiment, the three-way outlet valve 290 can provide a flow path for the cooling fluid from the fluid-to-air heat exchanger 120, bypassing the fluid-to-fluid heat exchanger 130, such as for maintenance, replacement, repair, or another operating issue.

In at least one embodiment, the system 200 can include one or more pumps and/or other valves to control the flow of the cooling fluid through the system 200. In at least one embodiment, the system 200 can include one or more check and/or control valves 272 to selectively shut-off, throttle, or otherwise control flow of the cooling fluid through the fluid-to-air heat exchanger 120 and/or the fluid-to-fluid heat exchanger 130.

In at least one embodiment, the system 200 can include one or more controllers 300 for controlling one or more system components and/or the flow of cooling fluid through all or a portion of the system 200. In at least one embodiment, the controller 300 can control one or more system components and/or fluid flow based at least in part on one or more variables, such as input from one or more temperature sensors, flow sensors, thermostats, building management systems, other controllers, or any combination thereof. In at least one embodiment, the controller 300 can control the valves 272, the three-way inlet valve 280, the three-way outlet valve 290, one or more components of the chiller system 160, or any combination thereof, such as to control the flow of cooling fluid through the cooling fluid supply line 110, the fluid-to-air heat exchanger 120, the fluid-to-fluid heat exchanger 130, the cooling fluid return line 140, the chiller system 160, the cooling fluid supply coupler 210, the cooling fluid return coupler 240, or any combination thereof.

In at least one embodiment, the controller 300 can monitor heat loads or cooling demands associated with information technology (IT) equipment and/or other components cooled by the fluid-to-air heat exchanger 120 and/or the fluid-to-fluid heat exchanger 130, and/or can control the flow of cooling fluid to provide adequate cooling to those components directly and/or through the fluid-to-air heat exchanger 120 and/or the fluid-to-fluid heat exchanger 130. In at least one embodiment, the controller 300 can mix warm cooling fluid from the fluid-to-air heat exchanger 120 with cold cooling fluid directly from the cooling fluid supply line 110 and/or the cooling fluid supply coupler 210 and direct the mixture to the fluid-to-fluid heat exchanger 130, such as when a temperature of the cooling fluid from the fluid-to-air heat exchanger 120 is inadequate to provide sufficient cooling to and/or through the fluid-to-fluid heat exchanger 130. In at least one embodiment, the controller 300 can direct all of the cooling fluid from the fluid-to-air heat exchanger 120 (and only the cooling fluid from the fluid-to-air heat exchanger 120) to and/or through the fluid-to-fluid heat exchanger 130, such as when a cooling load associated with the fluid-to-fluid heat exchanger 130 is relatively low.

In at least one embodiment, a method according to the disclosure can be used to more efficiently configure a cooling system, such as an existing cooling system having a cooling fluid supply line 110, a fluid-to-air heat exchanger 120, a fluid-to-fluid heat exchanger 130, a cooling fluid return line 140, or any combination thereof. In at least one embodiment, the method can include disconnecting an outlet 124 of the fluid-to-air heat exchanger 120 from the cooling fluid return line 140 and/or disconnecting an inlet 132 of the fluid-to-fluid heat exchanger 130 from the cooling fluid supply line 11, fluidically coupling the outlet 124 of the fluid-to-air heat exchanger 120 to the inlet 132 of the fluid-to-fluid heat exchanger 130, directly, through an inlet vale 280, or through an outlet valve 290, or any combination thereof. In at least one embodiment, the method can direct cooling fluid to flow from the cooling fluid supply line 110, through the fluid-to-air heat exchanger 120, through the fluid-to-fluid heat exchanger 130, and then to the cooling fluid return line 140.

In at least one embodiment, the method can include coupling an inlet valve 280 between the cooling fluid supply line 110, an inlet 122 of the fluid-to-air heat exchanger 120, and the inlet 132 of the fluid-to-fluid heat exchanger 130. In at least one embodiment, the method can include coupling an outlet valve 290 between the cooling fluid return line 140, the outlet 124 of the fluid-to-air heat exchanger 120, and an outlet 134 of the fluid-to-fluid heat exchanger 130. In at least one embodiment, inlet valve 280 and the outlet valve 290 can allow the fluid-to-air heat exchanger 120 and the fluid-to-fluid heat exchanger 130 to be selectively operated in series or parallel.

In at least one embodiment, a cooling system according to the disclosure can include a cooling fluid supply line for receiving cooling fluid at a first temperature from a cooling fluid chiller system, a fluid-to-air heat exchanger fluidically coupled to the cooling fluid supply line for selectively transferring heat from air to the cooling fluid and heating the cooling fluid to a second temperature, a fluid-to-fluid heat exchanger fluidically coupled to the fluid-to-air heat exchanger for selectively transferring heat from one or more cold plates to the cooling fluid and heating the cooling fluid to a third temperature, a cooling fluid return line fluidically coupled to the fluid-to-fluid heat exchanger and configured to return the cooling fluid at the third temperature to the cooling fluid chiller system, or any combination thereof. In at least one embodiment, the second temperature can be higher than the first temperature. In at least one embodiment, the third temperature can be higher than the first temperature and/or the second temperature. In at least one embodiment, the fluid-to-air heat exchanger and the fluid-to-fluid heat exchanger can be fluidically coupled in series between the cooling fluid supply line and the cooling fluid return line.

In at least one embodiment, any or all of the cooling fluid that flows through the fluid-to-air heat exchanger can flow or be routed through the fluid-to-fluid heat exchanger before entering the cooling fluid return line. In at least one embodiment, any or all of the cooling fluid entering the fluid-to-fluid heat exchanger can first flow through the fluid-to-air heat exchanger before entering the fluid-to-fluid heat exchanger. In at least one embodiment, the cooling fluid can enter the fluid-to-fluid heat exchanger at the second temperature or between the first temperature and the second temperature and/or exit the fluid-to-fluid heat exchanger at the third temperature.

In at least one embodiment, the fluid-to-air heat exchanger and the fluid-to-fluid heat exchanger can be combined into one unit and/or disposed within a single enclosure. In at least one embodiment, the enclosure can be disposed in one room of a building and the cold plates can be disposed within the same or another room of the building. In at least one embodiment, at least a portion of the cooling fluid chiller system can be disposed outside the building. In at least one embodiment, the system can include one cooling fluid supply coupler coupled to the enclosure and that fluidically couples the cooling fluid supply line to the fluid-to-air heat exchanger and/or one cooling fluid return coupler coupled to the enclosure and that fluidically couples the cooling fluid return line to the fluid-to-fluid heat exchanger, which can simplify installation of the system.

In at least one embodiment, the system can include a first three-way valve fluidically coupled to the cooling fluid supply coupler and/or the cooling fluid supply line. In at least one embodiment, the first three-way valve can be fluidically coupled between the cooling fluid supply coupler and the fluid-to-air heat exchanger, between the cooling fluid supply line and the fluid-to-air heat exchanger, between the fluid-to-air heat exchanger and the fluid-to-fluid heat exchanger, between the cooling fluid supply coupler and the fluid-to-fluid heat exchanger, between the cooling fluid supply line and the fluid-to-fluid heat exchanger, or any combination thereof.

In at least one embodiment, the first three-way valve can select between the cooling fluid at the first temperature from the cooling fluid supply coupler (or the cooling fluid supply line) and the cooling fluid at the second temperature from the fluid-to-air heat exchanger and supply the selected cooling fluid to the fluid-to-fluid heat exchanger, selectively mix the cooling fluid at the first temperature from the cooling fluid supply coupler (or the cooling fluid supply line) with the cooling fluid at the second temperature from the fluid-to-air heat exchanger and supply the mixed cooling fluid to the fluid-to-fluid heat exchanger, direct the cooling fluid at the first temperature from the cooling fluid supply coupler (or the cooling fluid supply line) to the fluid-to-air heat exchanger and/or the fluid-to-fluid heat exchanger, or any combination thereof.

In at least one embodiment, the system can include a second three-way valve fluidically coupled to the fluidically coupled to cooling fluid return coupler and/or the cooling fluid return line. In at least one embodiment, the three-way valve can be fluidically coupled between the cooling fluid return coupler and the fluid-to-air heat exchanger, between the cooling fluid return line and the fluid-to-air heat exchanger, between the fluid-to-air heat exchanger and the fluid-to-fluid heat exchanger, between the cooling fluid return coupler and the fluid-to-fluid heat exchanger, between the cooling fluid return line and the fluid-to-fluid heat exchanger, or any combination thereof. In at least one embodiment, the second three-way valve can direct the cooling fluid at the second temperature from the fluid-to-air heat exchanger to the cooling fluid return coupler, the cooling fluid return line, the fluid-to-fluid heat exchanger, or any combination thereof.

In at least one embodiment, a method according to the disclosure can be used to more efficiently configure a cooling system, such as an existing cooling system having a cooling fluid supply line, a fluid-to-air heat exchanger, a fluid-to-fluid heat exchanger, a cooling fluid return line, or any combination thereof. In at least one embodiment, the method can include disconnecting an outlet of the fluid-to-air heat exchanger from the cooling fluid return line, disconnecting an inlet of the fluid-to-fluid heat exchanger from the cooling fluid supply line, fluidically coupling the outlet of the fluid-to-air heat exchanger to the inlet of the fluid-to-fluid heat exchanger. In at least one embodiment, the method can direct cooling fluid to flow from the cooling fluid supply line, through the fluid-to-air heat exchanger, through the fluid-to-fluid heat exchanger, and then to the cooling fluid return line.

Other and further embodiments utilizing one or more aspects of the disclosure can be devised without departing from the Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other embodiments and not every embodiment of the inventions has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicant, but rather, in conformity with the patent laws, Applicant intends to fully protect all such modifications and improvements that come within the scope of the following claims.

## Claims

1. A cooling system comprising:
a cooling fluid supply line configured to receive cooling fluid at a first temperature from a cooling fluid chiller system;
a fluid-to-air heat exchanger fluidically coupled to the cooling fluid supply line and configured to selectively transfer heat from air to the cooling fluid and heat the cooling fluid to a second temperature, wherein the second temperature is higher than the first temperature;
a fluid-to-fluid heat exchanger fluidically coupled to the fluid-to-air heat exchanger and configured to selectively transfer heat from one or more cold plates to the cooling fluid and heat the cooling fluid to a third temperature, wherein the third temperature is higher than the first temperature; and
a cooling fluid return line fluidically coupled to the fluid-to-fluid heat exchanger and configured to return the cooling fluid at the third temperature to the cooling fluid chiller system.

2. The cooling system as set forth in claim 1, wherein the fluid-to-air heat exchanger and the fluid-to-fluid heat exchanger are fluidically coupled in series between the cooling fluid supply line and the cooling fluid return line.

3. The cooling system as set forth in claim 1 or 2, wherein at least a portion of the cooling fluid that flows through the fluid-to-air heat exchanger is routed through the fluid-to-fluid heat exchanger before entering the cooling fluid return line.

4. The cooling system as set forth in any preceding claim, wherein all of the cooling fluid that flows through the fluid-to-air heat exchanger is routed through the fluid-to-fluid heat exchanger before entering the cooling fluid return line, and/or,
wherein at least a portion of the cooling fluid entering the fluid-to-fluid heat exchanger is routed through the fluid-to-air heat exchanger before entering the fluid-to-fluid heat exchanger.

5. The cooling system as set forth in any preceding claim, wherein all of the cooling fluid entering the fluid-to-fluid heat exchanger is routed through the fluid-to-air heat exchanger before entering the fluid-to-fluid heat exchanger.

6. The cooling system as set forth in any preceding claim, wherein the cooling fluid enters the fluid-to-fluid heat exchanger at the second temperature, or,
wherein the cooling fluid enters the fluid-to-fluid heat exchanger at between the first temperature and the second temperature.

7. The cooling system as set forth in any preceding claim, wherein the fluid-to-air heat exchanger and the fluid-to-fluid heat exchanger are disposed within an enclosure.

8. The cooling system as set forth in claim 7, wherein the enclosure is disposed in a first room of a building and the one or more cold plates are disposed within a second room of the building, and/or,
wherein at least a portion of the cooling fluid chiller system is disposed outside a building housing the enclosure.

9. The cooling system as set forth in claim 7 or 8, further comprising a cooling fluid supply coupler coupled to the enclosure and that fluidically couples the cooling fluid supply line to the fluid-to-air heat exchanger.

10. The cooling system as set forth in claim 9, further comprising a three-way valve fluidically coupled between the cooling fluid supply coupler and the fluid-to-air heat exchanger, between the fluid-to-air heat exchanger and the fluid-to-fluid heat exchanger, and between the cooling fluid supply coupler and the fluid-to-fluid heat exchanger.

11. The cooling system as set forth in claim 10, wherein the system is configured to select between the cooling fluid at the first temperature from the cooling fluid supply coupler and the cooling fluid at the second temperature from the fluid-to-air heat exchanger, and to supply, via the three-way valve, the selected cooling fluid to the fluid-to-fluid heat exchanger.

12. The cooling system as set forth in claim 10 or 11, wherein the system is configured to selectively mix the cooling fluid at the first temperature from the cooling fluid supply coupler with the cooling fluid at the second temperature from the fluid-to-air heat exchanger, and to supply, via the three-way valve, the mixed cooling fluid to the fluid-to-fluid heat exchanger, and or
wherein the system is configured to selectively direct, via the three-way valve, the cooling fluid at the first temperature from the cooling fluid supply coupler to either the fluid-to-air heat exchanger or the fluid-to-fluid heat exchanger.

13. The cooling system as set forth in claims 7 to 12, further comprising a cooling fluid return coupler coupled to the enclosure and that fluidically couples the cooling fluid return line to the fluid-to-fluid heat exchanger.

14. The cooling system as set forth in claim 13, further comprising a three-way valve fluidically coupled between the cooling fluid return coupler and the fluid-to-air heat exchanger, between the fluid-to-air heat exchanger and the fluid-to-fluid heat exchanger, and between the cooling fluid return coupler and the fluid-to-fluid heat exchanger and optionally,
wherein the system is configured to selectively direct, via the three-way valve, the cooling fluid at the second temperature from the fluid-to-air heat exchanger to either the cooling fluid return coupler or the fluid-to-fluid heat exchanger

15. The cooling system as set forth in any preceding claim, further comprising a first three-way valve fluidically coupled between the cooling fluid supply line and the fluid-to-air heat exchanger, between the fluid-to-air heat exchanger and the fluid-to-fluid heat exchanger, and between the cooling fluid supply line and the fluid-to-fluid heat exchanger.
